# EUROPEAN PATENT APPLICATION

(11) **EP 3 675 157 A1**
(43) Date of publication of application: **01.07.2020**
(21) Application number: 19195226.6
(22) Date of filing: 03.09.2019
(51) Int. Cl.: H01L 21/822, H01L 21/8238, H01L 27/06, H01L 27/092

(54) **SELF-ALIGNED STACKED GE/SI CMOS TRANSISTOR STRUCTURE**

(30) Priority: 28.12.2018 US 201816236113
(71) Applicant: Intel Corporation, Santa Clara, CA 95054-1549 (US)
(72) Inventor: RACHMADY, Willy, Beaverton, Oregon 97007 (US); DEWEY, Gilbert, Hillsboro, Oregon 97123 (US); JUN, Kimin, Portland, Oregon 97229 (US); LILAK, Aaron, Beaverton, Oregon 97007 (US); MUELLER, Brennen, Portland, Oregon 97229 (US); YOO, Hui Jae, Hillsboro, Oregon 97124-6463 (US); MORROW, Patrick, Portland, Oregon 97229 (US); PHAN, Anh, Beaverton, Oregon 97007 (US); HUANG, Cheng-Ying, Hillsboro, Oregon 97124 (US); MANNEBACH, Ehren, Tigard, Oregon 97223 (US)
(74) Representative: HGF Limited

(57) **Abstract**

An integrated circuit structure comprises a substrate and a stacked channel of self-aligned heterogeneous materials, wherein the stacked channel of self-aligned heterogeneous materials comprises an NMOS channel material over the substrate; and a PMOS channel material stacked over and self-aligned with the NMOS channel material. A heterogeneous gate stack is in contact the both the NMOS channel material and the PMOS channel material.

## Description

### TECHNICAL FIELD

Embodiments of the disclosure are in the field of integrated circuit structures and, in particular, a self-aligned stacked Ge/Si CMOS transistor structure.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and state-of-the-art fabrication processes may limit the possibility to further extend them into the sub-10 nm range. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 is illustrates a gate-cut cross-section of a stacked device architecture according to one embodiment.
Figure 2 illustrates an angled 3D view of integrated circuit structure incorporating a self-aligned stacked CMOS transistor structure in accordance with the present disclosure.
Figure 3 is an angled 3D view of integrated circuit structure incorporating a self-aligned stacked CMOS transistor structure after the stacked channel has been etched back to align with the heterogeneous gate stack and after formation source and drain regions.
Figure 4 is a flow diagram illustrating a process for fabricating a self-aligned stacked CMOS transistor structure comprising a stacked channel of self-aligned heterogeneous NMOS and PMOS materials, in accordance with some embodiments of the present disclosure.
Figures 5A-5K illustrate angled three-dimensional views of the self-aligned stacked CMOS transistor structure evolving as the fabrication process is performed, in accordance with some embodiments.
Figures 6A and 6B are top views of a wafer and dies that include one or more a self-aligned stacked Ge/Si CMOS transistor structure, in accordance with one or more of the embodiments disclosed herein.
Figure 7 illustrates a block diagram of an electronic system, in accordance with an embodiment of the present disclosure.
Figure 8 is a cross-sectional side view of an integrated circuit (IC) device assembly that may include one or more a self-aligned stacked Ge/Si CMOS transistor structure, in accordance with one or more of the embodiments disclosed herein.
Figure 9 illustrates a computing device in accordance with one implementation of the disclosure.

### DESCRIPTION OF THE EMBODIMENTS

Self-aligned stacked Ge/Si CMOS transistor structure is described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to structures and architectures for fabricating a self-aligned stacked CMOS transistor structure. Embodiments may include or pertain to one or more of stacked transistors, high-density transistors, CMOS, and group III-V materials. One or more embodiments may be implemented to realize high performance backend transistors to potentially increase 3D monolithic integration of high mobility channel material, such as Ge and III-V, on silicon to form stacked CMOS of future technology nodes of 3 nm and beyond.

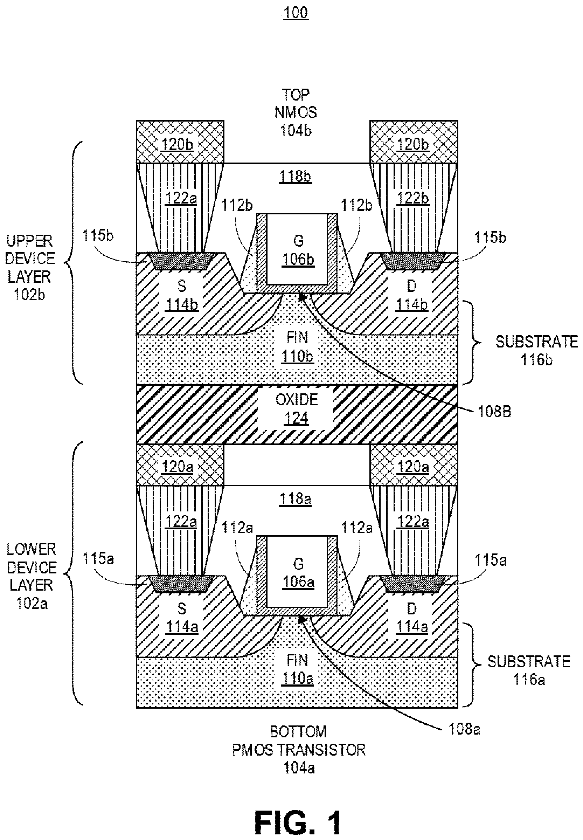

There is an increased need for structures and architectures for fabricating vertically stacked transistor devices. To provide context, Figure 1 illustrates a gate-cut cross-section of a stacked device architecture according to one embodiment. The stacked device architecture 100 comprises vertically stacked non-planar transistor devices formed in a lower device layer 102a and in an upper device layer 102b. The lower device layer 102a includes a first plurality of transistors 104a, which comprise Si PMOS transistors in one embodiment. Transistors 104a have a gate electrode 106a formed on a gate dielectric layer 108a formed on a fin 110a or channel. A pair of sidewall spacers 112a are formed along laterally opposite sidewalls of gate electrode 106a. In Figure 1, the fin 110a runs horizontally across the page, while the gate 106a runs in a z-direction into the page and wraps around the fin 110a. A pair of source and drain region 114a are formed on opposite sides of gate electrode 106a. As illustrated in Figure 1, the source and drain region 114a laterally extend completely beneath spacers 112a and slightly extend beneath or undercut the gate dielectric 108a and gate electrode 106a. When forming a p type field effect transistor (FET) where the majority carriers are holes, the silicon is doped to a p type conductivity. Silicide regions 115a are formed in the source and drain region 114a.

An interlayer dielectric 118a is formed over and around transistor 104a that isolates the transistor 104a from levels of metallization 120a used to interconnect the transistors 104a into function circuits, such as microprocessors, digital signal processors and memory devices. Metal contacts 120a and contact metal 122a are formed through the interlayer dielectric 118a and directly contact the silicide 115a formed on the source and drain region 114a to provide electrical connection between the first level of metallization 120a and the source and drain region 114a.

The upper device layer 102b includes a second structure comprising a second plurality of transistors 104b, which comprise NMOS transistors in one embodiment. Transistors 104b generally have the same structural components as transistors 104a in the lower device layer 102a except that when forming an n type FET where the majority carriers are electrons, the silicon is doped to an n type conductivity.

The upper device layer 102b is bonded onto the lower device layer 102a. Accordingly, the upper device layer 102b includes a bonding layer material, which may comprise an oxide layer 124. In further details, in one embodiment the lower-level of transistors are conventionally fabricated, and then a second layer of monocrystalline silicon or other semiconductor material may be layer transferred and oxide-oxide low temperature bonded to the top of the lower-level interlayer dielectric 118a.

While the vertically stacked non-planar transistor devices 102a and 102b is one example of current solutions to enable 3D monolithic stacked CMOS devices and works for its intended purpose, such a stacked transistor structure requires sequential transistor fabrication. Sequential fabrication of stacked transistors, however, is very expensive because the number of patterning steps is doubled, and is not scalable due to the level of interconnections required between the various device layers.

In accordance with one or more embodiments described herein, a stacked CMOS transistor structure is disclosed having a stacked channel of self-aligned heterogeneous materials. The stacked channel of self-aligned heterogeneous materials comprises an NMOS channel material over the substrate; and a PMOS channel material stacked over and self-aligned with the NMOS channel material. A heterogeneous gate stack is in contact the both the NMOS channel material and the PMOS channel material. In some embodiments, the NMOS channel material may comprise silicon (Si) and the PMOS channel material may comprises a group III-V material, such as germanium (Ge). In some embodiments, the stacked channel may be implemented as one or more of a fin structure, a nanowire structure and a nanoribbon structure.

A stacked CMOS transistor structure fabricated using such an architecture stacks PMOS over NMOS, rather next to each other, to reduce the area required for the devices by half. Consequently, the footprint of such a CMOS structure is reduced by approximately 50% by stacking the PMOS and NMOS and enables integration of the CMOS devices in unique architectures. Accordingly, the disclosed embodiments enable SRAM scaling of CMOS having different channel materials especially for process technology node of 3 nm and beyond.

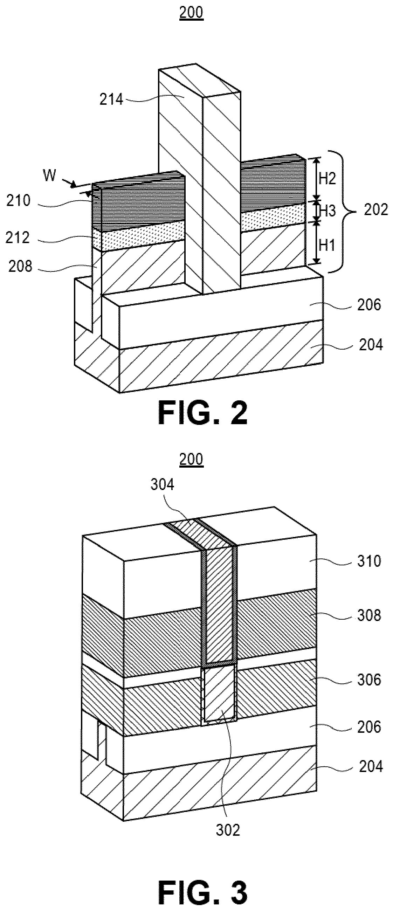

Figure 2 illustrates an angled 3D view of integrated circuit structure incorporating a self-aligned stacked CMOS transistor structure in accordance with the present disclosure. The stacked CMOS transistor structure 200 has a stacked channel 202 of self-aligned heterogeneous materials over a silicon (Si) substrate 204 and a shallow trench isolation (STI) oxide 206. The heterogeneous materials comprise an NMOS channel material 208 over the substrate 204, and a PMOS channel material 210 stacked over, and self-aligned with, the NMOS channel material 208. A heterogeneous gate stack 214 is in contact the both the NMOS channel material 208 stacked on a PMOS channel material 210. In some embodiments, the heterogeneous gate stack straddles the stacked channel 202 such that the gate stack is in contact with at least two sides of the bottom NMOS channel material 208 and at least three sides of the top PMOS channel material 210.

In some embodiments, the NMOS channel material 208 comprises an NMOS material such as silicon (Si), and the PMOS channel material 210 comprises a PMOS non-silicon group IV material such as germanium (Ge). In other embodiments, the group IV material may comprise silicon germanium (SiGe), or group III-V materials such as indium arsenide (InAs), indium antimony (InSb), indium arsenide antimony (InAsSb), gallium arsenide (GaAs), gallium arsenide antimony (GaAsSb), indium phosphorus (InP).

In some embodiments, a bonding layer 212 lies in between the NMOS channel material 208 and the PMOS channel material 210. In one embodiment, the bonding layer 212 comprises a dielectric material such as silicon dioxide (SiO2) or silicon carbon nitride (SiCN) or silicon nitride (SiN), for example.

In some embodiments, the NMOS channel material 208 and the PMOS channel material 210 and may have a height H1 and H2, respectively, which may be the same or different heights. In the embodiment where the height of H1 of the NMOS channel material 208 is the same as the height H2 of the PMOS channel material 210, the height H1 and H2 may be approximately 30 - 100 nm. In one embodiment, the bonding layer 212 has a height H3, which may range from approximately 5 - 50 nm and defines a separation distance between the NMOS channel material 208 and the PMOS channel material 210. In some embodiments, the NMOS channel material 208, the PMOS channel material 210 and the bonding layer 212 may have a same width W, which may range from approximately 4 - 15 nm in one embodiment.

Figure 3 is an angled 3D view of integrated circuit structure incorporating the self-aligned stacked CMOS transistor structure 200 after the stacked channel 202 has been etched back to align with the heterogeneous gate stack 214 and after formation of source and drain regions. In a further aspect of the disclosed embodiments, the heterogeneous gate stack 214 comprises an NMOS gate stack 302 on at least two sides of the NMOS channel material 208 (not visible), and a PMOS gate stack 304 over the NMOS gate stack 302 and on at least two sides of the PMOS channel material 210 (not visible). NMOS source and drain regions 306 are over the STI oxide 206 and substrate 204 and on opposite sides of the NMOS gate stack 302. PMOS source and drain regions 308 are over the NMOS source and drain regions 306, and are on opposite sides of the PMOS gate stack 304. An interlayer dielectric (ILD) 310 is formed over PMOS source and drain regions 308 to isolate the self-aligned stacked CMOS transistor structure 200 from subsequent levels of metallization (not shown) used to interconnect the self-aligned stacked CMOS transistor structure 200 into function circuits, such as microprocessors, digital signal processors and memory devices.

Notably, the architectural elements described above in the context of the self-aligned stacked CMOS transistor structure 200 may be applied to a wide array of other finFET architectures. For example, although Figure 2 depicts a non-planar transistors, in an alternative embodiment, a planar transistor architecture may be used. However, in preferred embodiments, any combination of non-planar transistor architectures may be stacked. For example, in one embodiment, the PMOS channel material 210 and the NMOS channel material 208 are formed as at least one of finFET, multi-gate, vertical circular gate (CG), and nanowire/nanoribbon architectures, respectively. For example, the same type of transistor architecture may be used for both the PMOS channel material 210 and the NMOS channel material 208, such that both the PMOS channel material 210 and the NMOS channel material 208 are formed using one or more non-planar transistor geometries that may include, but are not limited to, finFET, multi-gate, vertical circular gate, and nanowire/nanoribbon.

A stacked CMOS transistor structure 200 with self-aligned Ge/Si CMOS, such as a IVfinFET in accordance with the architectures above, may be fabricated by a variety of methods applying a variety of techniques and processing chamber configurations. Generally, the process may include forming a stacked channel 202 of self-aligned heterogeneous materials, where the stacked channel 202 of self-aligned heterogeneous materials comprises i) an NMOS channel material over the substrate; and ii) a PMOS channel material stacked over, and self-aligned with, the NMOS channel material. Thereafter, a heterogeneous gate stack is formed in contact the both the NMOS channel material and the PMOS channel material.

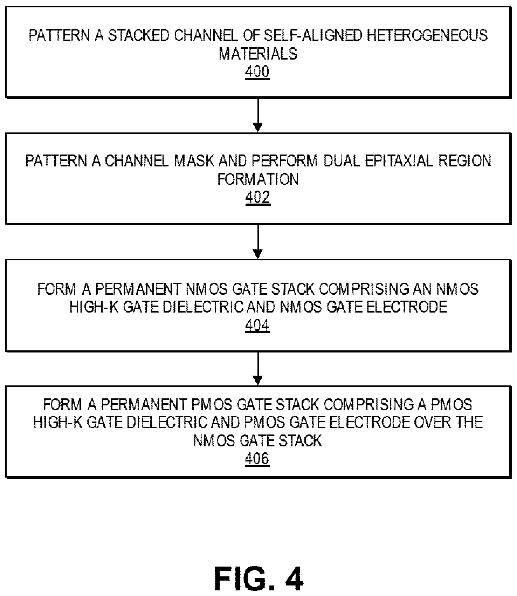

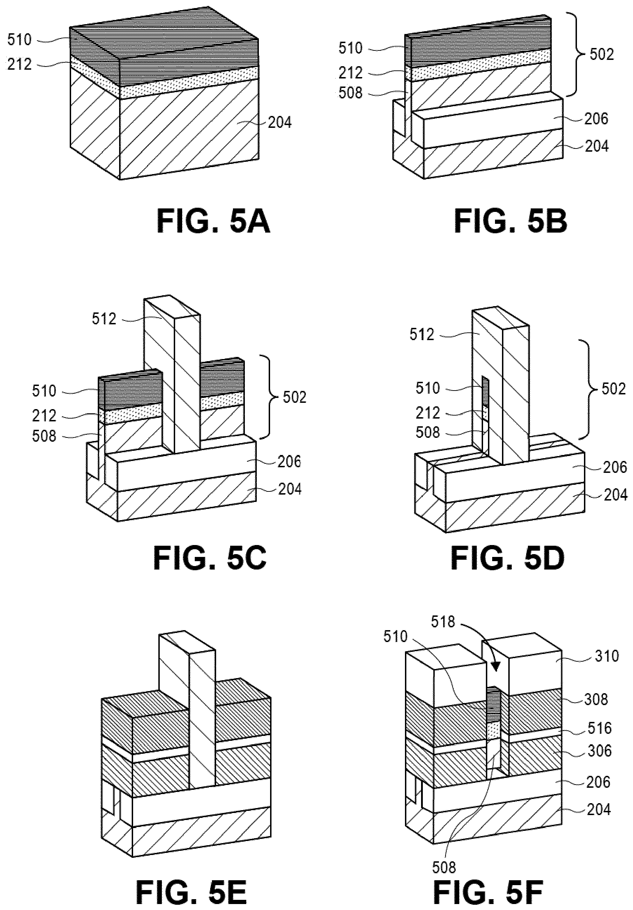

Figure 4 is a flow diagram illustrating a process for fabricating a stacked CMOS transistor structure comprising a stacked channel of self-aligned heterogeneous NMOS and PMOS materials, in accordance with some embodiments of the present disclosure. Figures 5A-5K illustrate angled three-dimensional views of the self-aligned stacked CMOS transistor structure evolving as the fabrication process is performed, in accordance with some embodiments, where like components from Figures 2 and 3 have like reference numerals.

Referring to Figure 4, the process may begin by patterning the stacked channel of self-aligned heterogeneous materials (block 400). In one embodiment, the stacked channel of self-aligned heterogeneous materials is patterned as a set of one or more fins. Patterning the set of one or more fins may be accomplished by depositing a bonding layer 212 comprising a dielectric material, such as silicon dioxide (SiO2), silicon carbon nitride (SiCN) or silicon nitride (SiN), onto a substrate wafer. SiCN is chosen as the dielectric layer between Ge and Si because it is sufficiently robust to survive throughout the subsequent processing operations. On a second wafer called a donor wafer, a Ge PMOS channel material 510 is epitaxially grown on a Si substrate via a thick buffer layer. This buffer layer is designed to bridge the lattice constant mismatch between Si and Ge. The donor wafer is then flipped and bonded to the bonding layer 212 on the substrate wafer to provide bonded wafers. The Si substrate and the buffer layer are subsequently removed or "cleaved" from the bonded wafers, leaving the Ge PMOS channel material 510 transferred onto the Si substrate 204.

Figure 5A illustrates the Si substrate 204, the bonding layer 212 and the Ge PMOS channel material 510 bonded to the bonding layer 212. Figure 5B illustrates that a portion of the Si substrate 204, the bonding layer 212 and the Ge PMOS channel material 510 of the bonded wafers are then etched to form one or more fins of the stacked channel 502, which comprises a Ge PMOS channel material 510 stacked over a Si NMOS channel material 508. Accordingly, stacked channel 502 is a self-aligned composite Ge/Si fin structure extending above a surface of the Si substrate 204. Since the Ge and Si are patterned simultaneously, they are therefore self-aligned. There is no added lithography for fin and subsequent dummy gate patterning so the same critical mask count is used as that for a single layer of CMOS. Figure 5B also illustrates that a STI oxide 206 is formed along the base of both front and backsides of the stacked channel 502 to separate adjacent fins.

In embodiments, the substrate 204 may be formed using a bulk silicon or a silicon-on-insulator substructure. In other implementations, the substrate may be formed using alternate materials, which may or may not be combined with silicon, that include but are not limited to germanium, indium antimonide, lead telluride, indium arsenide, indium phosphide, gallium arsenide, gallium antimonide, or other Group III-V materials. Although a few examples of materials from which the semiconductor substrate may be formed are described here, any material that may serve as a foundation upon which a semiconductor device may be built falls within the spirit and scope of the present invention.

Referring again to Figure 4, the process continues by patterning a channel mask and performing dual epitaxial region formation (block 402). The channel mask is formed to protect a portion of the fin that is to become the stacked channel region. While any known masking technique and material(s) may be employed, in some embodiments, the channel mask is a gate mandrel retained through a number of processes until being replaced in a "gate-last" finFET fabrication flow.

Figure 5C illustrates that in one embodiment, the channel mask is patterned by forming a dummy gate 512 over a portion of the fin or stacked channel 502. Any known sacrificial gate structure and fabrication techniques may be employed at operation 402 to form dummy gate 512 on at least two opposing sidewalls of fin or stacked channel 502. Dummy gate 512 is patterned into a stripe of sacrificial material straddling over the stacked channel 502 down to the STI oxide 206. Patterning the channel mask may further include forming optional gate sidewall spacer (not shown) adjacent to dummy gate 512. Any conventional self-aligned lateral spacer process may be employed at operation 402 to laterally stand-off subsequent processing from dummy gate 512. For example, a dielectric (e.g., silicon dioxide and/or silicon nitride) may be conformally deposited over the dummy gate 512. The material of spacers, in some embodiments, may include any suitable materials, such as dielectric materials, oxides (e.g., a silicon oxide material), and/or nitrides (e.g., a silicon nitride material).

Figure 5D show that in a further embodiment, portions of the fin or stacked channel 502 not protected by the dummy gate or channel mask are anisotropically etched away to be coplanar with the dummy gate 512 prior to epitaxial overgrowth of the Si NMOS source and drain regions and the Ge PMOS material source and drain regions.

Figure 5E shows the process after dual epitaxial region formation. In the first epitaxial region formation of the dual epitaxial region formation, NMOS source and drain regions 306 are deposited or grown over the STI oxide 206 and on opposite sides of the NMOS channel material 508 (which is no longer visible) under the dummy gate 512. An insulating layer 516 is formed on the NMOS source and drain regions 306. PMOS source and drain regions 308 are deposited or grown over the insulating layer 516 on opposite sides of the Ge PMOS channel material 510. Source and drain regions 306 and 308 may be grown, for example, by any of metal-organic chemical vapor deposition (MOCVD), molecular beam epitaxy (MBE), or hydride vapor phase epitaxy (HVPE).

In some embodiments, the source and drain regions 306 and 308 may be grown after performing an etch-under-cut (EUC) process. In some such embodiments, the source and drain regions may extend under spacers and/or under the gate stack, and such extended portions may be referred to as source and drain tips or extensions, for example. In some embodiments, the source and drain may be completely in the substrate, may be a portion of the substrate (e.g., including doping or otherwise altered), may be over the substrate, or any combination thereof. In some embodiments, source and drain regions may include any suitable materials and suitable dopants, depending on the end use or target application. For example, in an embodiment where substrate includes silicon and the transistor device is to be an n-type MOSFET, source and drain regions may both include n-type doped silicon (e.g., where phosphorus is the n-type dopant). In some embodiments, any suitable source and drain material and optional doping schemes may be used, depending on the end use or target application.

Referring again to Figure 4, the process continues by replacing the channel mask with a permanent NMOS gate stack comprising an NMOS high-K gate dielectric and NMOS gate electrode (block 404). Figure 5F illustrates that the operation may begin by forming an interlayer dielectric (ILD) 310 over PMOS source and drain regions 308 to isolate the self-aligned stacked CMOS transistor structure 200 from subsequent levels of metallization (not shown). Figure 5F also illustrates that a gate replacement process forms a gate trench 518 by removing dummy gate using, for example, wet and/or dry etch processes to expose the Ge PMOS channel material 510 and the Si NMOS channel material 508.

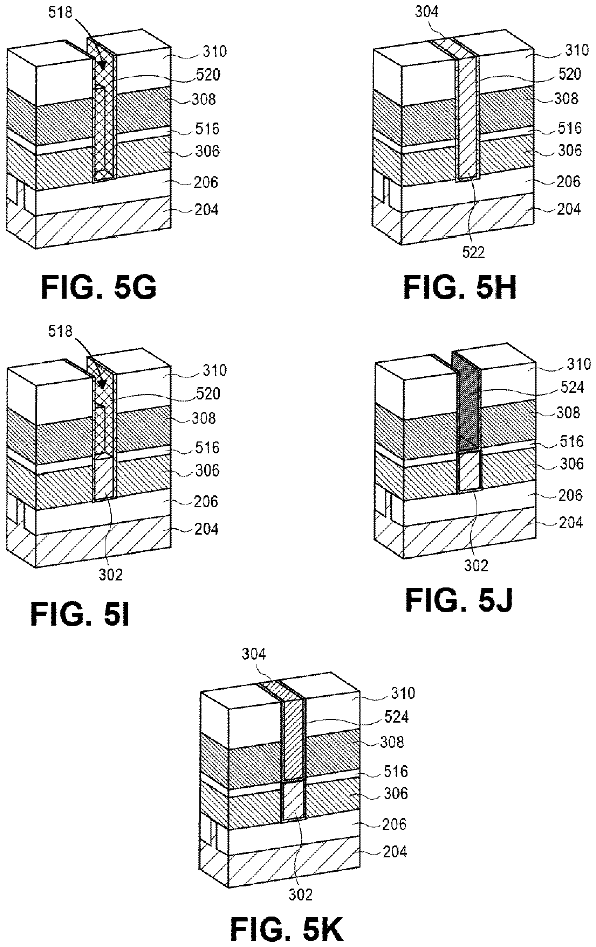

The permanent NMOS gate stack 302 (Fig. 3) comprises a NMOS high-K gate dielectric and an NMOS gate electrode. Figure 5G illustrates that the gate replacement includes forming the NMOS gate stack 302 by conformally depositing a gate dielectric, such as an NMOS high-K material 520, in the gate trench 518, and in particular over sidewalls of the fin. Figure 5H illustrates the formation of the NMOS gate stack 302 further includes depositing an NMOS gate electrode material 522 in the gate trench 518 over the NMOS high-K material 520. Figure 5I illustrates the process after the NMOS gate electrode material 522 is recessed back in the gate trench 518 to form the NMOS gate stack 302. In one embodiment, the NMOS gate electrode material 522 is recessed down to approximately level with the middle of the insulating layer 516 formed over the NMOS source and drain regions 306 to form the NMOS gate stack 302.

In an embodiment, NMOS gate electrode material 522 includes at least one N-type work function metal for the N-type transistor. For an N-type transistor, metals that may be used for the NMOS gate electrode material 522 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide).

Referring again to Figure 4, the gate replacement process further includes forming a permanent PMOS gate stack 304 (Fig. 3) comprising a PMOS high-K gate dielectric and a PMOS gate electrode over the NMOS gate stack (block 406). Figure 5J illustrates that formation of the PMOS gate stack 304 further includes conformally depositing a gate dielectric, such as a PMOS high-K material 524, in the gate trench 518 over the NMOS gate electrode 302. Figure 5K illustrates the process further includes depositing an PMOS gate electrode material in the gate trench 518 over the PMOS high-K material 524 to complete the PMOS gate stack 304.

In an embodiment, gate dielectric layers 520 and 524 are composed of a high-K material. For example, in one embodiment, the gate dielectric layers are composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof.

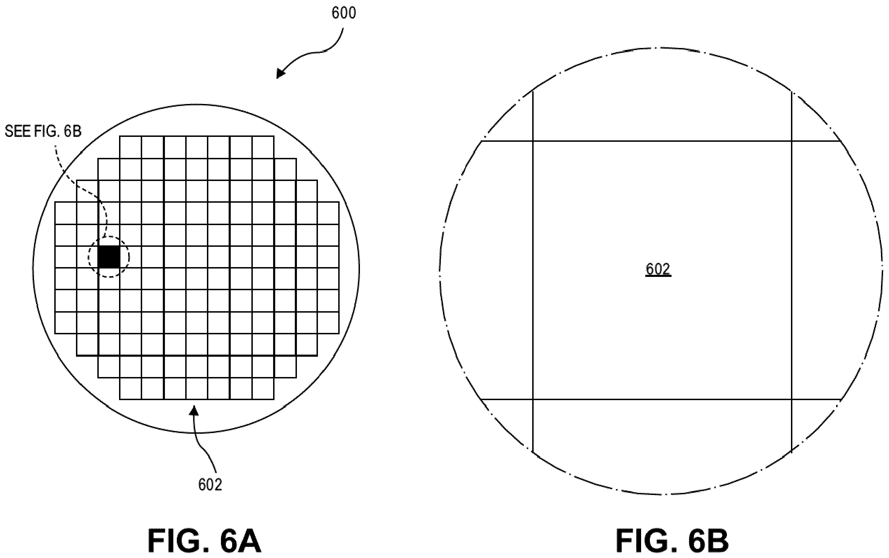

The integrated circuit structures described herein may be included in an electronic device. As an example of one such apparatus, Figures 6A and 6B are top views of a wafer and dies that include one or more a self-aligned stacked Ge/Si CMOS transistor structure, in accordance with one or more of the embodiments disclosed herein.

Referring to Figures 6A and 6B, a wafer 600 may be composed of semiconductor material and may include one or more dies 602 having integrated circuit (IC) structures formed on a surface of the wafer 600. Each of the dies 602 may be a repeating unit of a semiconductor product that includes any suitable IC (e.g., ICs including one or more a self-aligned stacked Ge/Si CMOS transistor structure, such as described above. After the fabrication of the semiconductor product is complete, the wafer 600 may undergo a singulation process in which each of the dies 602 is separated from one another to provide discrete "chips" of the semiconductor product. In particular, structures that include embedded non-volatile memory structures having an independently scaled selector as disclosed herein may take the form of the wafer 600 (e.g., not singulated) or the form of the die 602 (e.g., singulated). The die 602 may include one or more embedded non-volatile memory structures based independently scaled selectors and/or supporting circuitry to route electrical signals, as well as any other IC components. In some embodiments, the wafer 600 or the die 602 may include an additional memory device (e.g., a static random access memory (SRAM) device), a logic device (e.g., an AND, OR, NAND, or NOR gate), or any other suitable circuit element. Multiple ones of these devices may be combined on a single die 602. For example, a memory array formed by multiple memory devices may be formed on a same die 602 as a processing device or other logic that is configured to store information in the memory devices or execute instructions stored in the memory array.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

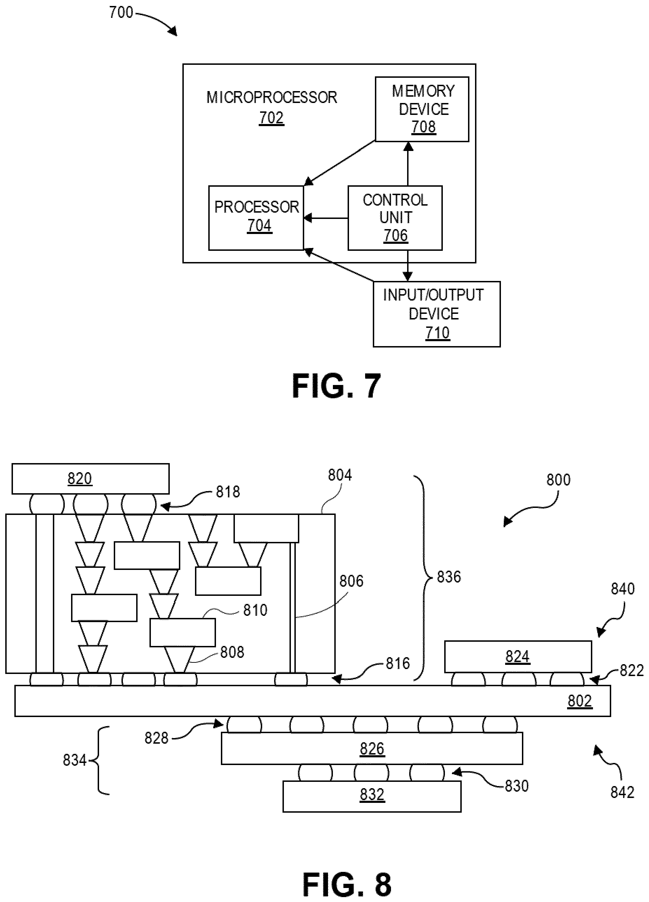

Figure 7 illustrates a block diagram of an electronic system 700, in accordance with an embodiment of the present disclosure. The electronic system 700 can correspond to, for example, a portable system, a computer system, a process control system, or any other system that utilizes a processor and an associated memory. The electronic system 700 may include a microprocessor 702 (having a processor 704 and control unit 706), a memory device 708, and an input/output device 710 (it is to be appreciated that the electronic system 700 may have a plurality of processors, control units, memory device units and/or input/output devices in various embodiments). In one embodiment, the electronic system 700 has a set of instructions that define operations which are to be performed on data by the processor 704, as well as, other transactions between the processor 704, the memory device 708, and the input/output device 710. The control unit 706 coordinates the operations of the processor 704, the memory device 708 and the input/output device 710 by cycling through a set of operations that cause instructions to be retrieved from the memory device 708 and executed. The memory device 708 can include a non-volatile memory cell as described in the present description. In an embodiment, the memory device 708 is embedded in the microprocessor 702, as depicted in Figure 7. In an embodiment, the processor 704, or another component of electronic system 700, includes one or more a self-aligned stacked Ge/Si CMOS transistor structure, such as those described herein.

Figure 8 is a cross-sectional side view of an integrated circuit (IC) device assembly that may include one or more a self-aligned stacked Ge/Si CMOS transistor structure, in accordance with one or more of the embodiments disclosed herein.

Referring to Figure 8, an IC device assembly 800 includes components having one or more integrated circuit structures described herein. The IC device assembly 800 includes a number of components disposed on a circuit board 802 (which may be, e.g., a motherboard). The IC device assembly 800 includes components disposed on a first face 840 of the circuit board 802 and an opposing second face 842 of the circuit board 802. Generally, components may be disposed on one or both faces 840 and 842. In particular, any suitable ones of the components of the IC device assembly 800 may include a number of a self-aligned stacked Ge/Si CMOS transistor structure, such as disclosed herein.

In some embodiments, the circuit board 802 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 802. In other embodiments, the circuit board 802 may be a non-PCB substrate.

The IC device assembly 800 illustrated in Figure 8 includes a package-on-interposer structure 836 coupled to the first face 840 of the circuit board 802 by coupling components 816. The coupling components 816 may electrically and mechanically couple the package-on-interposer structure 836 to the circuit board 802, and may include solder balls (as shown in Figure 8), male and female portions of a socket, an adhesive, an underfill material, and/or any other suitable electrical and/or mechanical coupling structure.

The package-on-interposer structure 836 may include an IC package 820 coupled to an interposer 804 by coupling components 818. The coupling components 818 may take any suitable form for the application, such as the forms discussed above with reference to the coupling components 816. Although a single IC package 820 is shown in Figure 8, multiple IC packages may be coupled to the interposer 804. It is to be appreciated that additional interposers may be coupled to the interposer 804. The interposer 804 may provide an intervening substrate used to bridge the circuit board 802 and the IC package 820. The IC package 820 may be or include, for example, a die (the die 602 of Figure 6B), or any other suitable component. Generally, the interposer 804 may spread a connection to a wider pitch or reroute a connection to a different connection. For example, the interposer 804 may couple the IC package 820 (e.g., a die) to a ball grid array (BGA) of the coupling components 816 for coupling to the circuit board 802. In the embodiment illustrated in Figure 8, the IC package 820 and the circuit board 802 are attached to opposing sides of the interposer 804. In other embodiments, the IC package 820 and the circuit board 802 may be attached to a same side of the interposer 804. In some embodiments, three or more components may be interconnected by way of the interposer 804.

The interposer 804 may be formed of an epoxy resin, a fiberglass-reinforced epoxy resin, a ceramic material, or a polymer material such as polyimide. In some implementations, the interposer 804 may be formed of alternate rigid or flexible materials that may include the same materials described above for use in a semiconductor substrate, such as silicon, germanium, and other group III-V and group IV materials. The interposer 804 may include metal interconnects 810 and vias 808, including but not limited to through-silicon vias (TSVs) 806. The interposer 804 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art.

The IC device assembly 800 may include an IC package 824 coupled to the first face 840 of the circuit board 802 by coupling components 822. The coupling components 822 may take the form of any of the embodiments discussed above with reference to the coupling components 816, and the IC package 824 may take the form of any of the embodiments discussed above with reference to the IC package 820.

The IC device assembly 800 illustrated in Figure 8 includes a package-on-package structure 834 coupled to the second face 842 of the circuit board 802 by coupling components 828. The package-on-package structure 834 may include an IC package 826 and an IC package 832 coupled together by coupling components 830 such that the IC package 826 is disposed between the circuit board 802 and the IC package 832. The coupling components 828 and 830 may take the form of any of the embodiments of the coupling components 816 discussed above, and the IC packages 826 and 832 may take the form of any of the embodiments of the IC package 820 discussed above. The package-on-package structure 834 may be configured in accordance with any of the package-on-package structures known in the art.

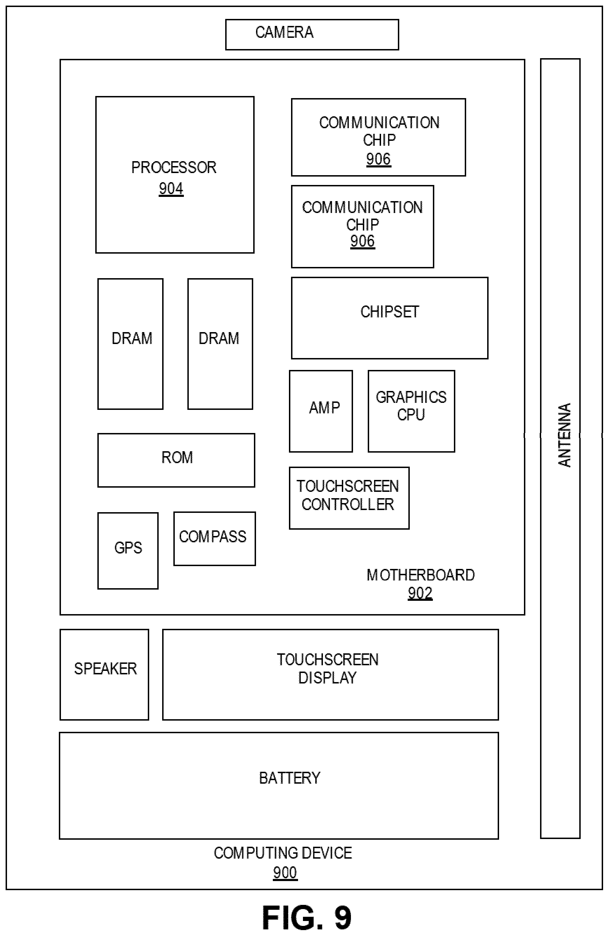

Figure 9 illustrates a computing device 900 in accordance with one implementation of the disclosure. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the disclosure, the integrated circuit die of the processor includes one or more a self-aligned stacked Ge/Si CMOS transistor structure, in accordance with implementations of embodiments of the disclosure. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of embodiments of the disclosure, the integrated circuit die of the communication chip includes one or more a self-aligned stacked Ge/Si CMOS transistor structure, in accordance with implementations of embodiments of the disclosure.

In further implementations, another component housed within the computing device 900 may contain an integrated circuit die that includes one or more a self-aligned stacked Ge/Si CMOS transistor structure, in accordance with implementations of embodiments of the disclosure.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

Thus, embodiments described herein include a self-aligned stacked Ge/Si CMOS transistor structure.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.
Example embodiment 1: An integrated circuit structure comprises a substrate and a stacked channel of self-aligned heterogeneous materials, wherein the stacked channel of self-aligned heterogeneous materials comprises an NMOS channel material over the substrate; and a PMOS channel material stacked over and self-aligned with the NMOS channel material. A heterogeneous gate stack is in contact the both the NMOS channel material and the PMOS channel material.
Example embodiment 2: The integrated circuit structure of example embodiment 1, wherein the NMOS channel material comprises silicon (Si).
Example embodiment 3: The integrated circuit structure of example embodiment 1 or 2, wherein the PMOS channel material comprises a PMOS non-Si group IV material.
Example embodiment 4: The integrated circuit structure of example embodiment 3, wherein the PMOS non-silicon group IV material comprises germanium (Ge).
Example embodiment 5: The integrated circuit structure of example embodiment 1, 2, 3, or 4, wherein the NMOS channel material and the PMOS channel material have different heights.
Example embodiment 6: The integrated circuit structure of example embodiment 1, 2, 3, 4, or 5, wherein the NMOS channel material and the PMOS channel material both have a height of approximately 30 - 100 nm.
Example embodiment 7: The integrated circuit structure of example embodiment 1, 2, 3, 4, 5, or 6, further comprising a bonding layer in-between the NMOS channel material and the PMOS channel material.
Example embodiment 8: The integrated circuit structure of example embodiment 7, wherein the bonding layer comprises silicon dioxide (SiO2), silicon carbon nitride (SiCN) or silicon nitride (SiN).
Example embodiment 9: The integrated circuit structure of example embodiment 7, wherein the bonding layer has a height of approximately 5 - 50 nm.
Example embodiment 10: The integrated circuit structure of example embodiment 7, wherein the NMOS channel material, the PMOS channel material, and the bonding layer of a width of approximately 4-15 nm.
Example embodiment 11: The integrated circuit structure of example embodiment 1, 2, 3, 4, 5, 6, 7, 8, 9, or 10, wherein the heterogeneous gate stack straddles the stacked channel such that the gate stack is in contact with at least two sides of the bottom NMOS channel material and at least three sides of the top PMOS channel material.
Example embodiment 12: The integrated circuit structure of example embodiment 1, 2, 3, 4, 5, 6, 7, 8, 9, 10, or 11, wherein the heterogeneous gate stack comprises an NMOS gate stack on at least two sides of the NMOS channel material, and a PMOS gate stack over the NMOS gate stack and on at least two sides of the PMOS channel material.
Example embodiment 13: The integrated circuit structure of example embodiment 1, 2, 3, 4, 5, 6, 7, 8, 9, 10, 11, or 12, wherein the PMOS channel material and the NMOS transistor material are formed using one or more of non-planar transistor geometries including a finFET, multi-gate, vertical circular gate, and nanowire/nanoribbon.
Example embodiment 14: A stacked CMOS transistor structures comprises a stacked channel of self-aligned heterogeneous materials, wherein the stacked channel of self-aligned heterogeneous materials comprises an NMOS channel material over a substrate and a PMOS channel material stacked over the NMOS channel material. A heterogeneous gate stack is in contact the both the NMOS channel material and the PMOS channel material, wherein the heterogeneous gate stack comprises an NMOS gate stack on at least two sides of the NMOS channel material, and a PMOS gate stack on at least two sides of the PMOS channel material. NMOS source and drain regions are over the substrate on opposite sides of the NMOS gate stack. PMOS source and drain regions are over the NMOS gate stack and the NMOS source and drain regions on opposite sides of the PMOS gate stack.
Example embodiment 15: The stacked CMOS transistor structure of example embodiment 14, wherein the NMOS channel material comprises silicon (Si).
Example embodiment 16: The stacked CMOS transistor structure of example embodiment 14, or 15, wherein the PMOS channel material comprises a PMOS non-silicon group IV material.
Example embodiment 17: The stacked CMOS transistor structure of example embodiment 15, 16 or 17, wherein the PMOS non- silicon group IV material comprises germanium (Ge).
Example embodiment 18: The stacked CMOS transistor structure of example embodiment 14, 15, 16, or 17, wherein the NMOS channel material and the PMOS channel material both have a height of approximately 30 - 100 nm.
Example embodiment 19: The stacked CMOS transistor structure of example embodiment 14, 15, 16, 17, or 18, further comprising a bonding layer in-between the NMOS channel material and the PMOS channel material.
Example embodiment 20: The stacked CMOS transistor structure of example embodiment 14, 15, 16, 17, 18, or 19, wherein the PMOS channel material and the NMOS transistor material are formed using one or more of non-planar transistor geometries including a finFET, multi-gate, vertical circular gate, and nanowire/nanoribbon.
Example embodiment 21: A method of fabricating an integrated circuit structure comprises forming a stacked channel of self-aligned heterogeneous materials, wherein the stacked channel of self-aligned heterogeneous materials comprises an NMOS channel material over the substrate, and a PMOS channel material stacked over and self-aligned with the NMOS channel material. A heterogeneous gate stack is formed in contact the both the NMOS channel material and the PMOS channel material.
Example embodiment 22: The method of example embodiment 21, wherein forming the stacked channel of self-aligned heterogeneous materials further comprises: patterning the stacked channel of self-aligned heterogeneous materials as a set of one or more fins by the following. A bonding layer comprising a dielectric material is deposited onto a substrate wafer. On a donor wafer, a Ge PMOS channel material is epitaxially grown on a Si substrate comprising the NMOS channel material via a thick buffer layer. The donor wafer is flipped over and bonded to the bonding layer of the substrate wafer to provide bonded wafers. The Si substrate and the buffer layer are removed from the bonded wafers. A portion of the NMOS channel material, the bonding layer and the Ge PMOS channel material of the bonded wafers are etched to form the one or more fins of a stacked channel. An oxide is formed along the base of both front and back sides of the stacked channel to separate adjacent one of the one or more fins.
Example embodiment 23: The method of example embodiment 21 or 22, wherein forming the heterogeneous gate stack formed in contact the both the NMOS channel material and the PMOS channel material further comprises: patterning a channel mask and performing dual epitaxial region formation. Patterning the channel mask further comprises: forming a dummy gate over a portion of the stacked channel. Portions of the one or more fins not protected by the dummy gate are etched away to be coplanar with the dummy gate. NMOS source and drain regions are deposited or grown over the STI oxide and on opposite sides of the NMOS channel material. An insulating layer is formed on the NMOS source and drain regions. PMOS source and drain regions are deposited or grown over the insulating layer on opposite sides of the Ge PMOS channel material.
Example embodiment 24: The method of example embodiment 23, wherein forming the stacked channel of self-aligned heterogeneous materials further comprises replacing the channel mask with a permanent NMOS gate stack comprising an NMOS high-K gate dielectric and NMOS gate electrode by the following. A gate trench is formed by removing the dummy gate to expose the Ge PMOS channel material and the Si NMOS channel material. A gate dielectric comprising an NMOS high-K material is conformally deposited in the gate trench. An NMOS gate electrode material is deposited in the gate trench over the NMOS high-K material.
Example embodiment 25: the method of example embodiment 24, wherein forming the stacked channel of self-aligned heterogeneous materials further comprises forming a permanent PMOS gate stack comprising a PMOS high-K gate dielectric and a PMOS gate electrode over the NMOS gate stack. Formation of the PMOS gate stack further includes conformally depositing a gate dielectric comprising a PMOS high-K material in remaining areas of the gate trench over the NMOS gate electrode; and depositing an PMOS gate electrode material in the gate trench over the PMOS high-K material to complete the PMOS gate stack.

## Claims

1. An integrated circuit structure, comprising:
a substrate;
a stacked channel of self-aligned heterogeneous materials, the stacked channel of self-aligned heterogeneous materials comprising:
an NMOS channel material over the substrate; and
a PMOS channel material stacked over and self-aligned with the NMOS channel material; and
a heterogeneous gate stack in contact the both the NMOS channel material and the PMOS channel material.

2. The integrated circuit structure of claim 1, wherein the NMOS channel material comprises silicon (Si).

3. The integrated circuit structure of claim 1, wherein the PMOS channel material comprises a PMOS non-silicon group III-V material; and optionally
wherein the PMOS non-silicon group IV material comprises germanium (Ge).

4. The integrated circuit structure of claim 1, wherein the NMOS channel material and the PMOS channel material have different heights; or
the NMOS channel material and the PMOS channel material both have a height of approximately 30 - 100 nm.

5. The integrated circuit structure of claim 1, further comprising a bonding layer in-between the NMOS channel material and the PMOS channel material.

6. The integrated circuit structure of claim 5, wherein:
the bonding layer comprises silicon dioxide (SiO2), silicon carbon nitride (SiCN) or silicon nitride (SiN); or
the bonding layer has a height of approximately 5 - 50 nm; or
the NMOS channel material, the PMOS channel material, and the bonding layer of a width of approximately 4-15 nm.

7. The integrated circuit structure of claim 1, wherein the heterogeneous gate stack straddles the stacked channel such that the heterogeneous gate stack is in contact with at least two sides of the NMOS channel material and at least three sides of the top PMOS channel material.

8. The integrated circuit structure of claim 1, wherein the heterogeneous gate stack comprises an NMOS gate stack on at least two sides of the NMOS channel material, and a PMOS gate stack over the NMOS gate stack and on at least two sides of the PMOS channel material.

9. The integrated circuit structure of claim 1, wherein the PMOS channel material and the NMOS channel material are formed using one or more of non-planar transistor geometries including a finFET, multi-gate, vertical circular gate, and nanowire/nanoribbon.

10. A stacked CMOS transistor structure, comprising:
a stacked channel of self-aligned heterogeneous materials, the stacked channel of self-aligned heterogeneous materials comprising:
an NMOS channel material over a substrate; and
a PMOS channel material stacked over the NMOS channel material;
a heterogeneous gate stack in contact the both the NMOS channel material and the PMOS channel material, the heterogeneous gate stack comprising:
an NMOS gate stack on at least two sides of the NMOS channel material; and
a PMOS gate stack on at least two sides of the PMOS channel material;
NMOS source and drain regions over the substrate on opposite sides of the NMOS gate stack; and
PMOS source and drain regions over the NMOS gate stack and the NMOS source and drain regions on opposite sides of the PMOS gate stack.

11. The stacked CMOS transistor structure of claim 10, wherein:
the NMOS channel material comprises silicon (Si); or
the PMOS channel material comprises a PMOS non-silicon group IV material; or
the NMOS channel material and the PMOS channel material both have a height of approximately 30 - 100 nm; or
further comprising a bonding layer in-between the NMOS channel material and the PMOS channel material; or
the PMOS channel material and the NMOS channel material are formed using one or more of non-planar transistor geometries including a finFET, multi-gate, vertical circular gate, and nanowire/nanoribbon.

12. A method of fabricating an integrated circuit structure, the method comprising:
forming a stacked channel of self-aligned heterogeneous materials, wherein the stacked channel of self-aligned heterogeneous materials comprises:
an NMOS channel material over the substrate; and
a PMOS channel material stacked over and self-aligned with the NMOS channel material; and
a heterogeneous gate stack formed in contact the both the NMOS channel material and the PMOS channel material.

13. The method of claim 12, wherein forming the stacked channel of self-aligned heterogeneous materials further comprises:
patterning the stacked channel of self-aligned heterogeneous materials as one or more fins by:
depositing a bonding layer comprising a dielectric material onto a substrate wafer;
on a donor wafer, epitaxially growing a Ge PMOS channel material on a Si substrate comprising the NMOS channel material via a buffer layer;
flipping the donor wafer over and bonding the donor wafer to the bonding layer of the substrate wafer to provide bonded wafers;
removing the Si substrate and the buffer layer from the bonded wafers;
etching a portion of the NMOS channel material, the bonding layer and the Ge PMOS channel material of the bonded wafers to form the one or more fins of a stacked channel; and
forming an oxide along a base of both front and back sides of the stacked channel to separate adjacent one of the one or more fins.

14. The method of claim 13, wherein forming the heterogeneous gate stack formed in contact the both the NMOS channel material and the PMOS channel material further comprises:
patterning a channel mask and performing dual epitaxial region formation, wherein patterning the channel mask further comprises:
forming a dummy gate over a portion of the stacked channel;
etching portions of the one or more fins not protected by the dummy gate away to be coplanar with the dummy gate;
depositing or growing NMOS source and drain regions over a STI oxide and on opposite sides of the NMOS channel material;
forming an insulating layer on the NMOS source and drain regions; and
depositing or growing PMOS source and drain regions over the insulating layer on opposite sides of the Ge PMOS channel material.

15. The method of claim 14, wherein forming the stacked channel of self-aligned heterogeneous materials further comprises:
replacing the channel mask with a permanent NMOS gate stack comprising an NMOS high-K gate dielectric and NMOS gate electrode by:
forming a gate trench by removing the dummy gate to expose the Ge PMOS channel material and the Si NMOS channel material;
conformally depositing a first gate dielectric comprising an NMOS high-K material in the gate trench; and
depositing an NMOS gate electrode material in the gate trench over the NMOS high-K material.
